# EUROPÄISCHE PATENTANMELDUNG

(11) **EP 0 588 784 A1**
(43) Veröffentlichungstag der Anmeldung: **23.03.1994**
(21) Anmeldenummer: 93890183.2
(22) Anmeldetag: 17.09.1993
(51) Int. Cl.: H03K 19/08, H03K 19/0175, H03K 19/01

(54) **Integrierte BICMOS-Schaltungsanordnung**

(30) Priorität: 17.09.1992 AT 1858/92
(71) Anmelder: AUSTRIA MIKRO SYSTEME INTERNATIONAL AKTIENGESELLSCHAFT, A-8141 Unterpremstätten (AT)
(72) Erfinder: Dietrich, Armgarth, Dr., D-01097 Dresden (DE)
(74) Vertreter: Haffner, Thomas M., Dr.

(57) **Zusammenfassung**

Bei einer integrierten BICMOS-Schaltungsanordnung mit komplementären MOS-Transistoren, welche am Ausgang den vollen Spannungshub zur Verfügung stellen soll und auch bei hohen Betriebstemperaturen und kleinen Schaltzeiten betriebssicher sein soll, ist von der Basis eines ersten Bipolar-Transistors (7) nach Masse (6) die Source-Drain-Strecke eines ersten p-JFET's (2) parallelgeschaltet, wobei sein Gate mit dem Kollektor des ersten Bipolar-Transistors (7), dem Drain des n-MOS-Transistors (3) auf der Eingangsseite und mit dem Ausgang (8) verbunden ist. Die Source-Drain-Strecke eines zweiten p-JFET (4) ist zwischen der Basis und dem Emitter eines zweiten Bipolar-Transistors (9) parallelgeschaltet, wobei das Gate des zweiten p-JFET (4) mit dem Kollektor des zweiten Bipolar-Transistors (9), dem Source des p-MOS-Transistors (5) auf der Eingangsseite und der Betriebsspannung (10) verbunden ist und der Emitter des Bipolar-Transistors (9) gleichfalls eine Verbindung mit dem Ausgang (8) aufweist (Fig. 2).

## Beschreibung

Die Erfindung betrifft eine integrierte Bipolar-CMOS-(BICMOS)-Schaltungsanordnung mit komplementären MOS-Transistoren, die vom Eingang gesteuert werden, und einer Reihenschaltung eines ersten und eines zweiten Bipolar-Transistors, die einen Ausgang steuert, wobei ein n-Kanal-MOS-Transistor zwischen dem Kollektor und der Basis des ersten Bipolar-Transistors und ein p-Kanal-MOS-Transistor zwischen dem Kollektor und der Basis eines zweiten Bipolar-Transistors angeordnet sind und mit Widerstanden, JFET's und MOS- und Bipolar-Transistoren, die zur Basis-Emitter-Strecke des ersten und zweiten Bipolar Transistors parallelgeschaltet sind, insbesondere für Anwendungen im Niedervoltbereich.

In hochintegrierten Schaltkreisen müssen Ausgangstransistoren von Schaltungsanordnungen lange Leitungsbahnen speisen. Diese langen Leitungsbahnen weisen zum Substrat erhebliche Kapazitäten auf, die bis zu 200 pF groß sein können. Um diese Kapazitäten in sehr kurzer Zeit (Sub-ns-Bereich) umladen zu können, müssen die Ausgangstransistoren in dieser kurzen Zeit große Ströme zur Verfügung stellen. MOS-Transistoren müssen daher wegen ihrer geringen Steilheit großflächig ausgelegt werden. Bipolar-Transistoren weisen zwar die erforderliche große Steilheit auf, benötigen aber zur Ansteuerung einen Basisstrom. Eine Kombination von MOS-Transistoren auf der Eingangsseite und Bipolar-Transistoren auf der Ausgangsseite einer integrierten Schaltungsanordnung ist daher eine optimale Lösung.

Eine bekannte BICMOS-Schaltungsanordnung, wie in Fig. 1 dargestellt (EP-B1-0212004, Fig. 1), sol] den Stand der Technik näher erläutern.

Der Eingang 1' ist auf die Gates der MOS-Transistoren 3', 5', 13' und 14' geführt. Die MOS-Transistoren 13' und 14' stellen dabei den bekannten CMOS-Inverter dar, der parallel zur eigentlichen BICMOS-Schaltung angeordnet ist. Der MOS-Transistor 3' ist zwischen Kollektor und Basis des Bipolar-Transistors 7' und der MOS-Transistor 5' zwischen Kollektor und Basis des Bipolar-Transistors 9' angeordnet. Die Bipolar-Transistoren 7' und 9' sind in Reihe geschaltet, und der Zusammenschaltungspunkt beider Transistoren ist mit dem Ausgang 8' verbunden. Diese gesamte Anordnung stellt einen Inverter dar, d. h. liegt am Eingang 1' ein H(high)-Pegel, so erscheint am Ausgang 8' ein L(low)-Pegel. Bei H am Eingang sind die beiden MOS-Transistoren 3' und 13' leitend, d. h. eine Eingangsspannung von z. B. 5 V ist wesentlich größer als die Schwellspannung dieser beiden MOS-Transistoren, und somit kann in den beiden MOS-Transistoren ein Strom fließen. Der Strom durch den MOS-Transistor 3' wird im Bipolar-Transistor 7' verstärkt, und der Kollektor des Bipolar-Transistors 7' und die Ströme durch die MOS-Transistoren 3' und 13' entladen die parasitäre Ausgangskapazität Cout. Es muß nur die parasitäre Ausgangskapazität Cout entladen werden, denn die Transistoren 5', 9' und 14' sind gesperrt, vorausgesetzt, der Umschaltvorgang erfolgt in sehr kurzer Zeit und alle Bauelemente schalten ideal.

Die Ausgangskapazität wird nun bis VBE (Spannung zwischen Basis und Emitter) des Bipolar-Transistors 7' durch die Transistoren 3', 7' und 13' entladen. Danach übernimmt der MOS-Transistor 13' allein die Restentladung von Cout. Diese Entladung bis auf Massepotential ist unbedingt erforderlich, damit ein nachfolgender Inverter - gleich welcher Art - sicher gesperrt wird, denn schon bei einer kleinen Restspannung am Ausgang 8' können in den nachfolgenden Invertern unerwünschte Ströme fließen.

Schaltet der Eingang 1' von H nach L, so werden die Transistoren 3', 7' und 13' gesperrt. Die MOS-Transistoren 3' und 13' werden sofort gesperrt. Der Bipolar-Transistor 7' leitet noch kurze Zeit weiter, bis die Ladung in der Basis des Bipolar-Transistors 7' abgebaut ist. Gleichzeitig beginnen nun die Transistoren 5', 9', und 14' zu leiten. Die Kapazität Cout wird bis VDD-VBE durch die Transistoren 5', 9' und 14' aufgeladen. Danach übernimmt wieder der CMOS-Inverter (Transistor 14') die Aufladung der Kapazität bis auf VDD-Potential (VDD = Betriebsspannung).

In der EP-B1-0212004 wird nun vorgeschlagen, die Ansteuerung des parallelgeschalteten CMOS-Inverters zu ändern. Es werden ein weiterer Bipolar-Transistor 31, Dioden 33, 35 und 37 und ein weiterer MOS-Transistor 39 verwendet (Fig. 2). In den Fig. 4 und 5 der EP-B1-0212004 werden noch zwei Schaltungsvarianten vorgestellt, die zusätzliche MOS-Transistoren zur Ansteuerung der Bipolar-Transistoren und des parallelgeschalteten CMOS-Inverters verwenden. Alle bisher verwendeten Bezugszeichen beziehen sich auf die EP-B1-0212004.

Diese vorgestellten Schaltungsanordnungen haben den Nachteil, daß sie bauelementeintensiv sind, besonders dann, wenn zwei oder mehr Eingänge vorhanden sein müssen. Es vervielfachen sich dann nicht nur die Transistoren, die die Bipolar-Transistoren ansteuern, sondern auch die Bauelemente im parallelgeschalteten CMOS-Inverter. Weiterhin wird der Eingang 1' mit mindestens vier Gatekapazitäten belastet, was zu einer Erhöhung der Schaltzeiten im System führt. Solche Schaltungsanordnungen benötigen nicht nur mehr Platz auf dem Chip, sondern es wird auch die Zuverlässigkeit durch die große Anzahl der Bauelemente und Verbindungen herabgesetzt.

In der am 16.Dezember 1992 veröffentlichten EP-A1-0518847 der Anmelderin wird eine BICMOS-Schaltungsanordung vorgeschlagen, die an Stelle des parallelgeschalteten CMOS-Inverters für den n- und p-MOS-Transistor jeweils eine Reihenschaltung von zwei komplementären MOS-Depletion- bzw. Sperrschichtfeldeffekt(JFET)-Transistoren (Pos. 7 und 8 in der EP-A1-0518847) vorsieht, wobei diese Reihenschaltungen vom Ausgang angesteuert werden. Der Eingang wird zwar in dieser Schaltungsanordnung durch die zusätzlichen Bauelemente nicht belastet, jedoch ist der Bauelementeaufwand ebenfalls hoch und nicht immer stehen im verwendeten Prozeß MOS-Depletion-Transistoren zur Verfügung.

Die in der EP-A1-0099100 vorgestellten Schaltungsanordnungen betreffen ebenfalls BICMOS-Schaltungsanordnungen. Diese haben aber den großen Nachteil, daß der Ausgangspegel im H(high)-Zustand nicht den vollen Wert der Betriebsspannung VDD und im L(low)-Zustand nicht Massepotential erreicht. In beiden Fallen ist der Ausgangspegel um die Basis-Emitterflußspannung VBE der Bipolar-Transistoren abgesenkt bzw. angehoben. Das gilt auch für die Schaltungsanordnungen gemäß EP-A2-0145004 und EP-A1-0134731. Bei z.B. VDD = 2 Volt und VBE = 0,5 Volt ist der Ausgangspegel im H-Zustand VOH ≃ 1,5 Volt. Eine nachfolgende gleichartige Schaltungsanordnung benötigt aber eine Spannung, die größer ist als VBE + VTH ≃ 1,2 Volt (VTH = Schwellspannung des n-MOS-Transistors). Bei VOH ≃ VBE + VTH funktioniert diese Zusammenschaltung nicht mehr. Der Einsatz solcher Schaltungsanordnungen, die eine Pegelabsenkung aufweisen, ist im Niedervoltbereich daher nur bedingt oder nicht möglich.

Das Ziel der Erfindung ist es, eine integrierte BICMOS-Schaltungsanordnung anzugeben, die am Ausgang den vollen Spannungshub zur Verfügung stellt, die platzsparend und mit wenigen Bauelementen aufgebaut ist, die gewährleistet, daß die Bipolar-Transistoren sicher auch bei den höchsten Umgebungstemperaturen gesperrt bleiben und die sehr kleine Schaltzeiten garantiert.

Die Lösung dieser Aufgabe besteht darin, daß in der bekannten BICMOS-Schaltungsanordnung mit komplementären MOS-Transistoren, die vom Eingang gesteuert werden, und einer Reihenschaltung eines ersten und eines zweiten Bipolar-Transistors, die einen Ausgang steuert, wobei ein n-Kanal-MOS-Transistor zwischen dem Kollektor und der Basis des ersten Bipolar-Transistors und ein p-Kanal-MOS-Transistor zwischen dem Kollektor und der Basis eines zweiten Bipolar-Transistors angeordnet sind und mit Widerständen, JFET's und MOS- und Bipolar-Transistoren, die zur Basis-Emitter-Strecke des ersten und zweiten Bipolar-Transistors parallelgeschaltet sind, wobei das Gate des MOS-Transistors mit dem Ausgang verbunden sein kann, von der Basis eines ersten Bipolar-Transistors nach Masse die Source-Drain-Strecke eines ersten p-JFET angeordnet ist, daß das Gate des ersten p-JFET mit dem Kollektor des ersten Bipolar-Transistors, dem Drain des n-MOS-Transistors auf der Eingangsseite und mit dem Ausgang verbunden ist, daß die Source-Drain-Strecke eines zweiten p-JFET zwischen der Basis und dem Emitter eines zweiten Bipolar-Transistors angeordnet ist, daß das Gate des zweiten p-JFET mit dem Kollektor des zweiten Bipolar-Transistors, dem Source des p-MOS-Transistors auf der Eingangsseite und der Betriebsspannung verbunden ist und daß der Emitter des Bipolar-Transistors gleichfalls mit dem Ausgang verbunden ist.

In einer vorteilhaften Ausführungsform sind der erste p-JFET und der erste Bipolar-Transistor zusammen in einem ersten n-Wannengebiet und der zweite p-JFET und der zweite Bipolar-Transistor zusammen in einem weiteren n-Wannengebiet angeordnet, so daß eine erhebliche Platzeinsparung erzielt wird.

In einer weiteren Variante ist zur Verbesserung des Sperrverhaltens der Bipolar-Transistoren die Drain-Source-Strecke eines zusätzlichen n-MOS-Transistor zwischen der Basis und dem Emitter des zweiten Bipolar-Transistors angeordnet, wobei sein Gate mit der Betriebsspannung verbunden ist. Die Drain-Source-Strecke eines weiteren n-MOS-Transistors ist zwischen der Basis und dem Emitter des ersten Bipolar-Transistors angeordnet, und sein Gate ist mit der Basis des zweiten Bipolar-Transistors verbunden.

Damit wird erreicht, daß beim H-Pegel am Ausgang die Basis-Emitter-Strecke des ersten Bipolar-Transistors durch den weiteren n-MOS-Transistor kurzgeschlossen wird und somit die im Basisraum des ersten Bipolar-Transistors gespeicherte Ladung schnell abgebaut wird, was zu einer Verkürzung der Schaltzeiten und nach dem Abbau der Ladung zu einer Reduzierung des Sperrstromes im ersten Bipolar-Transistor führt. Beim L-Pegel am Ausgang wird die Basis-Emitter-Strecke des zweiten Bipolar-Transistors durch den zusätzlichen n-MOS-Transistor nahezu kurzgeschlossen, so daß auch hier nach dem Umschaltvorgang und dem Abbau der Ladung im Basisraum des zweiten Bipolar-Transistors der Sperrstrom durch das definierte Potential an der Basis reduziert wird.

Um die Schaltzeiten weiter zu reduzieren, wird in einer Weiterentwicklung der n-MOS-Transistor auf der Eingangsseite als Doppeltransistor mit gemeinsamen Source- und Gateanschlüssen und zwei Drainanschlüssen ausgebildet und der zweite Drainanschluß des n-MOS-Doppeltransistors mit der Basis des zweiten Bipolar-Transistors verbunden. Die Drain-Source-Strecke eines weiteren n-MOS-Transistors ist zwischen Basis und Emitter des ersten Bipolar-Transistors angeordnet, und sein Gate ist mit der Basis des zweiten Bipolar-Transistors verbunden. Damit wird neben den oben erwähnten Vorteilen ein noch zügigerer Abbau der Ladung im Basisraum des zweiten Bipolar-Transistors erreicht, weil der n-MOS-Doppeltransistor sofort mit dem Eingangs-H-Pegel eingeschaltet wird.

Die Erfindung wird nachfolgend an Hand von Ausführungsbeispielen näher erläutert.
Es zeigen Fig. 1 den eingangs beschriebenen Stand der Technik gemäß EP-A1-0212004,

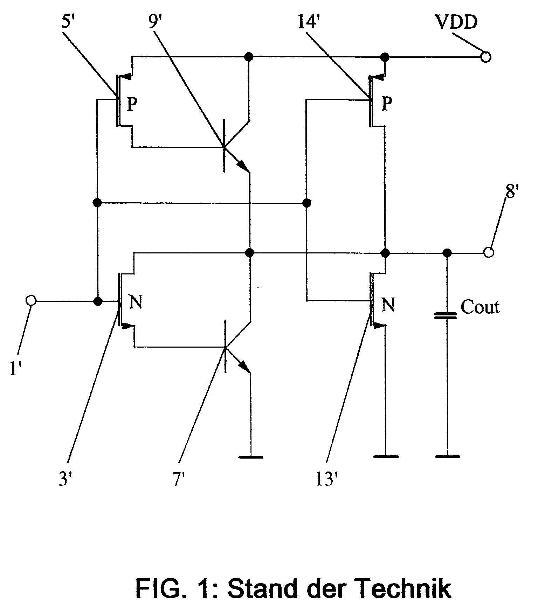

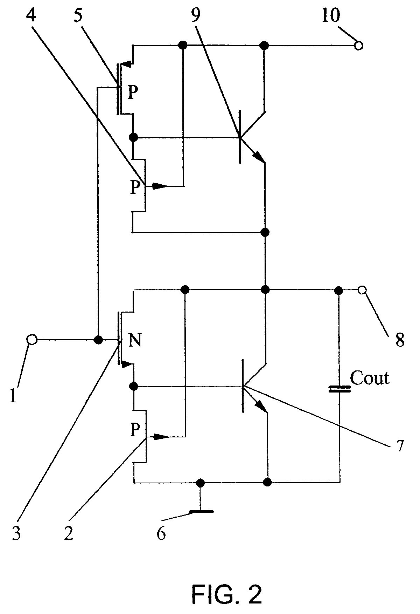

Fig. 2 die erfindungsmäßige Schaltungsanordnung,

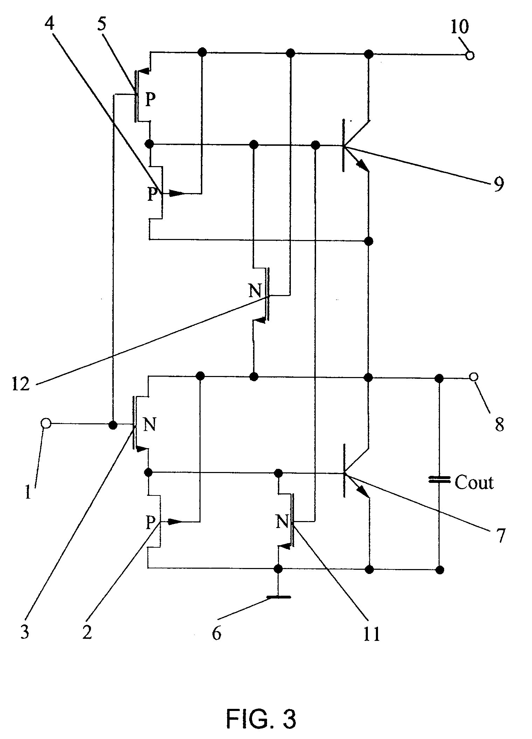

Fig. 3 eine Erweiterung der erfindungsgemäßen Schaltungsanordnung und

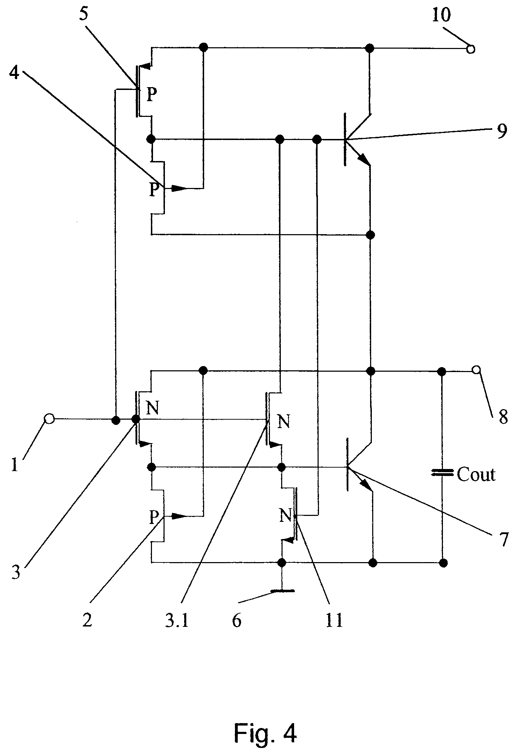

Fig. 4 eine Verbesserung der erfindungsgemäßen Schaltungsanordnung hinsichtlich der Schaltzeiten.

Gemäß Fig. 2 ist der Eingang 1 mit den Gates der eingangsseitigen MOS-Transistoren 3 und 5 verbunden, wobei der MOS-Transistor 3 ein n-Kanal-MOS-Transistor und der MOS-Transistor 5 ein p-Kanal-MOS-Transistor ist. Der Drainanschluß des n-MOS-Transistors 3 ist mit dem Kollektor des ersten Bipolar-Transistors 7 zusammengeschaltet, während sein Sourceanschluß mit der Basis des ersten Bipolar-Transistors 7 verbunden ist. Zwischen der Basis und dem Emitter des ersten Bipolar-Transistors 7 ist die Source-Drain-Strecke des ersten p-Sperrschichtfeldeffekt-Transistors 2 (p-JFET) angeordnet. Das Gate dieses p-JFET's ist mit dem Kollektor des ersten Bipolar-Transistors 7 verbunden. Alle diese Anschlüsse sind mit dem Ausgang 8 verbunden.

Der p-MOS-Transistor 5 ist - wie bekannt - zwischen der Basis und dem Kollektor des zweiten Bipolar-Transistors 9 angeordnet. Zwischen der Basis und dem Emitter des Bipolar-Transistors 9 ist nun ein zweiter p-Sperrschichtfeldeffekt-Transistor 4 (p-JFET) angeordnet, wobei sein Gate mit dem Kollektor des zweiten Bipolar-Transistors 9 verbunden ist. Diese Anschlüsse sind mit der Betriebsspannung 10 verbunden. Der Emitter des zweiten Bipolar-Transistors 9 ist mit dem Ausgang 8 verbunden, während der Emitter des ersten Bipolar-Transistors 7 mit Masse 6 zusammengeschaltet ist.

Dynamisch wirkt diese Schaltungsanordnung wie folgt: Bei einem Anstieg der Eingangsspannung von 0 Volt auf 5 Volt wird der n-MOS-Transistor 3 leitend. Eine parasitäre Kapazität Cout zwischen dem Ausgang 8 und der Masse 6 sei auf die Betriebsspannung von 5 Volt aufgeladen. Der p-JFET 2 ist in diesem Fall gesperrt, denn sein Gate weist ein Potential von 5 Volt auf, und dieser Wert ist größer als die Pinch-off-Spannung des p-JFET 2 von beispielsweise 3 Volt. Source und Drain des p-JFET 2 sind gegenüber dem Gate in Sperrichtung vorgespannt und zwar so stark, daß der leitende Kanal im p-JFET 2 vollständig abgeschnürt wird. Damit fließt kein Strom durch den p-JFET 2.

Der Strom durch den n-MOS-Transistor 3 kann vollständig in die Basis des ersten Bipolar-Transistors 7 fließen und dort einen Kollektorstrom erzeugen, der die parasitäre Kapazität Cout schnell entlädt. Bei dieser Entladung sinkt nun die Spannung am Ausgang 8 ab, da über den oberen Zweig der Schaltung, bestehend aus den Transistoren 4, 5 und 9, keine Nachladung erfolgen kann. Diese Transistoren befinden sich alle im nichtleitenden Zustand. Die Spannung am Ausgang 8 sinkt sehr schnell bis auf die Basis-Emitterflußspannung VBE des ersten Bipolar-Transistors 7 ab (≃ 0,5 ... 0,6 Volt). Danach fließt kein nennenswerter Strom mehr in die Basis. Nun leitet aber bereits der p-JFET 2, und über diesen und den n-MOS-Transistor 3 wird die parasitäre Ausgangskapazität Cout vollständig entladen. Der p-JFET 2 beginnt bereits ab der Pinch-off-Spannung etwas zu leiten, d. h. im Beispiel ab etwa 3 Volt fließt durch diesen p-JFET bereits ein Strom. Der Strom durch den p-JFET 2 nimmt dann aber bei fallender Ausgangsspannung immer mehr zu und erreicht den größten Wert, wenn die Ausgangsspannung etwa den Wert der Basis-Emitterflußspannung VBE erreicht hat.

Der obere Zweig der Schaltung wird gesperrt, da durch den p-MOS-Transistor 5 kein Strom fließt. Hier ist die Spannung zwischen Gate und Source etwa gleich 0 Volt, so daß dieser p-MOS-Transistor 5 sicher gesperrt ist. Damit ist auch der zweite Bipolar-Transistor 9 gesperrt. Im ersten Moment liegt am Ausgang 8 noch die volle Betriebsspannung an, d. h. die parasitäre Ausgangskapazität Cout ist auf 5 Volt aufgeladen, und der p-JFET 4 ist vollständig leitend und schließt die Basis-Emitter-Strecke des zweiten Bipolar-Transistors 9 kurz, d. h. selbst Sperrströme durch den p-MOS-Transistor 5, die bei hohen Temperaturen verstärkt auftreten, werden am zweiten Bipolar-Transistor 9 vorbeigeleitet und können somit keinen Kollektorstrom im zweiten Bipolar-Transistor 9 erzeugen. Die gespeicherte Ladung in der Basis wird teilweise über den p-JFET 4 abgebaut. Bei der weiteren Entladung der parasitären Ausgangskapazität Cout, wenn die Spannung am Ausgang 8 absinkt, beginnt ab einer Ausgangsspannung von 2 Volt der p-JFET 4 in den nichtleitenden Zustand überzugehen, d. h. bei einer Ausgangsspannung von 0 Volt ist dann der p-JFET 4 vollständig gesperrt, und die Basis des zweiten Bipolar-Transistor 9 weist ein floatendes Potential um ≃ 0,5 Volt auf.

Nach dieser Übergangsphase sind nun der n-MOS-Transistor 3 und der p-JFET 2 vollständig leitend und der MOS-Transistor 5 und der p-JFET 4 vollständig gesperrt. Der erste Bipolar-Transistor 7 ist nun ebenfalls gesperrt, denn die Spannung zwischen Basis und Emitter ist etwa gleich 0 Volt. Durch den zweiten Bipolar-Transistor 9 fließt ebenfalls kein Strom, da der p-MOS-Transistor 5 gesperrt ist.

Wird am Eingang 1 von 5 Volt auf 0 Volt umgeschaltet, so werden die Zustände in den beiden Zweigen vertauscht. Der untere Zweig wird vollständig gesperrt, während der obere vollständig leitend wird, so daß die Spannung am Ausgang 8 auf den Wert der Betriebsspannung 10 ansteigen kann. Im einzelnen geschieht jetzt folgender Vorgang:

Der p-MOS-Transistor 5 wird vollständig leitend. Es kann ein Strom in die Basis des zweiten Bipolar-Transistors 9 fließen, der dort verstärkt wird und zur Aufladung der parasitären Ausgangskapazität Cout dient. In der Übergangsphase wird noch ein geringer Strom durch den n-MOS-Transistor 3 abfließen. Dieser wird gegen Null gehen, wenn die Eingangsspannung den Wert der Schwellspannung dieses Transistors erreicht hat. Der erste Bipolar-Transistor 7 ist ohnehin gesperrt, und so kann über diesen unteren Zweig kein Strom abfließen.

Die Spannung am Ausgang 8 baut sich nun auf. Hat diese Ausgangsspannung den Wert (VDD - VBE) erreicht (VDD = Betriebsspannung; VBE = Basis-Emitterflußspannung), so kann kein Strom mehr durch den zweiten Bipolar-Transistor 9 zur Aufladung der Ausgangskapazität Cout fließen. Nun ist aber - wie vorher im unteren Zweig - der p-JFET 4 vollständig leitend geworden. Die Aufladung der Ausgangskapazität Cout erfolgt nun bis auf den Wert von VDD über den p-MOS-Transistor 5 und den p-JFET 4.

Am Ende dieses Umschaltprozesses sind der p-MOS-Transistor 5 und der p-JFET 4 vollständig leitend, während der n-MOS-Transistor 3 und der p-JFET 2 vollständig gesperrt sind. Beide Bipolar-Transistoren 7 und 9 sind ebenfalls wieder im nichtleitenden Zustand.

Fig. 3 zeigt eine Ergänzung der erfindungsmäßigen Schaltungsanordnung nach Fig. 2. Es wurden die beiden n-MOS-Transistoren 11 und 12 ergänzt. Die Drain-Source-Strecke des weiteren n-MOS-Transistors 11 ist zwischen Basis und Emitter des ersten Bipolar-Transistors 7 angeordnet, während die des zusätzlichen n-MOS-Transistors 12 zwischen Basis und Emitter des zweiten Bipolar-Transistors 9 vorgesehen ist. Das Gate des weiteren n-MOS-Transistors 11 ist mit der Basis des zweiten Bipolar-Transistors 9 verbunden, während das Gate des zusätzlichen n-MOS-Transistors 12 mit der Betriebsspannung 10 verbunden ist.

Diese beiden n-MOS-Transistoren haben folgende Aufgabe:

Ist der obere Zweig der Schaltungsanordnung gesperrt, d. h. ist am Eingang 1 eine Spannung von 5 Volt vorhanden, so werden im eingeschwungenen Zustand der p-JFET 4 und der p-MOS-Transistor 5 gesperrt. Die Basis des zweiten Bipolar-Transistors 9 floated, d. h. das Potential an der Basis ist relativ undefiniert (wie bereits erwähnt ≃ 0,5 Volt). Um einen exakten Kurzschluß zwischen Basis und Emitter des zweiten Bipolar-Transistors 9 zu erreichen, damit dieser auch bei den höchsten Betriebstemperaturen sicher gesperrt ist, wird der zusätzliche n-MOS-Transistor 12 verwendet. Dieser zusätzliche n-MOS-Transistor 12 ist voll leitend, wenn die Spannung am Ausgang 8 etwa 0 Volt beträgt und sein Gate einen wesentlich größeren Spannungswert aufweist. Dieser zusätzliche n-MOS-Transistor 12 wird schon leitend, wenn die Ausgangsspannung auf einen Wert von (VDD - VTH) (VDD = Betriebsspannung; VTH = Schwellspannung des zusätzlichen n-MOS-Transistors 12) abgesunken ist. Ein Teil des Basissteuerstromes des zweiten Bipolar-Transistors 9 fließt dann nämlich auch noch über diesen zusätzlichen n-MOS-Transistor ab, so daß seine Größe optimiert werden muß. Er hat an sich nur die Funktion eines Widerstandes zu übernehmen.

Die gleiche Betrachtungsweise gilt für den unteren Zweig der Schaltungsanordnung. Sind der n-MOS-Transistor 3 und der p-JFET 2 gesperrt, so zeigt der Ausgang 8 ein Potential, das dem der Betriebsspannung 10 entspricht. Der erste Bipolar-Transistor 7 ist gesperrt und sein Basispotential floated (bei ≃ 0,5 Volt). Damit auch dieser erste Bipolar-Transistor 7 sicher bis zu den höchsten Betriebstemperaturen gesperrt bleibt, wurde der weitere n-MOS-Transistor 11 eingefügt. Da die Basis des zweiten Bipolar-Transistors 9 ebenfalls ein Potential aufweist, das dem der Betriebsspannung 10 entspricht, ist der weitere n-MOS-Transistor 11 voll durchgesteuert, d. h. Basis und Emitter des ersten Bipolar-Transistors 7 sind kurzgeschlossen. Dieser Kurzschluß bewirkt die vollständige Sperrung des ersten Bipolar-Transistors 7.

Fig. 4 zeigt eine verbesserte Schaltungsanordnung gegenüber der in Fig. 3 gezeigten bekannten Anordnung. Nach Fig. 3 wird der zusätzliche n-MOS-Transistor 12 vom Ausgang 8 gesteuert. Das bedeutet, daß erst der Ausgang 8 auf den Eingangsimpuls reagieren muß, ehe der zusätzliche n-MOS-Transistor 12 schalten kann. Das Durchlaufen des Signals vom Eingang zum Ausgang mit der nachfolgenden Reaktion des zusätzlichen n-MOS-Transistors 12 bringt einen Verlust an Schaltgeschwindigkeit. Um das zu verhindern, wird gemäß Fig. 4 eine Steuerung eines n-MOS-Transistors vom Eingang her vorgenommen. Dabei wird der n-MOS-Transistor 3 gemäß Fig. 3 als Doppeltransistor 3 und 3.1 ausgebildet, d. h. es wird ein Transistor mit zwei Drainanschlüssen verwendet. Der Gateanschluß beider Transistoren ist mit dem Eingang verbunden. Der Sourceanschluß beider Transistoren ist mit der Basis des ersten Bipolar- Transistors 7 verbunden.

Dynamisch bewirkt der n-MOS-Transistor 3.1 folgendes:

Liegt am Eingang 1 eine Spannung von 5 Volt an, so wird auch sofort der n-MOS-Transistor 3.1 eingeschaltet. Er entlädt die Basis des zweiten Bipolar-Transistors 9 und sein Strom trägt zur Erhöhung des Basisstromes des ersten Bipolar-Transistors 7 bei. Dieser Vorgang erfolgt nur während der Umschaltphase und trägt zur Entladung der parasitären Ausgangskapazität Cout und zur Verkürzung der Schaltzeiten bei. Im eingeschwungenen Zustand bewirkt dieser n-MOS-Transistor 3.1, daß das Potential an der Basis des zweiten Bipolar-Transistors 9 etwa Massepotential aufweist, da der p-JFET 2 leitend ist. Somit sind Basis und Emitter des zweiten Bipolar-Transistors 9 kurzgeschlossen und bewirken die einwandfreie Sperrung des zweiten Bipolar-Transistors 9.

Beim Umschalten des Eingangs 1 von 5 Volt auf 0 Volt durch einen vorhergehenden Transistor werden die n-MOS-Doppeltransistoren 3 und 3.1 sofort abgeschaltet. Für die Basis des zweiten Bipolar-Transistors 9 bedeutet das, daß der gesamte Strom vom p-MOS-Transistor 5 in die Basis des zweiten Bipolar-Transistors 9 fließen kann und so zur schnelleren Aufladung der Ausgangskapazität Cout beitragen kann. In diesem Fall sorgt dann auch wieder der weitere n-MOS-Transistor 11 für eine sichere Sperrung des ersten Bipolar-Transistors 7, da durch das hohe Potential an der Basis des zweiten Bipolar-Transistors 9 der weitere n-MOS-Transistor 11 sofort durchgesteuert wird und Basis und Emitter des ersten Bipolar-Transistors 7 kurzschließt.

Die Schaltungsanordnung gemäß Fig. 4 wird vorwiegend als Ausgangstreiber verwendet, da der vorhergehende Transistor mit drei Gatekapazitäten belastet wird und bei logischen Verknüpfungsschaltungen drei MOS-Transistoren pro Eingang verwendet werden müssen.

Die Schaltungsanordnungen gemäß Fig. 2 und 3 können dagegen vorteilhaft auch in Verknüpfungsschaltungen zum Einsatz kommen, da pro Eingang nur zwei MOS-Transistoren benötigt werden, wie das aus der herkömmlichen CMOS-Schaltungstechnik bekannt ist.

### Zusammenstellung der verwendeten Bezugszeichen

- 1: Eingang
- 2: erster p-Sperrschichtfeldeffekt-Transistor (p-JFET)
- 3: n-MOS-Transistor auf der Eingangsseite
- 3.1: n-MOS-Transistor parallel zum n-MOS-Transistor 3
- 4: zweiter p-Sperrschichtfeldeffekt-Transistor (p-JFET)
- 5: p-MOS-Transistor auf der Eingangsseite
- 6: Masse
- 7: erster Bipolar-Transistor
- 8: Ausgang
- 9: zweiter Bipolar-Transistor
- 10: Betriebsspannung VDD
- 11: weiterer n-MOS-Transistor
- 12: zusätzlicher n-MOS-Transistor

## Patentansprüche

1. Integrierte BICMOS-Schaltungsanordnung mit komplementären MOS-Transistoren (3,5), die vom Eingang (1) gesteuert werden, und einer Reihenschaltung eines ersten und eines zweiten Bipolar-Transistors (7,9), die einen Ausgang (8) steuert, wobei ein n-Kanal-MOS-Transistor (3) zwischen dem Kollektor und der Basis des ersten Bipolar-Transistors (7) und ein p-Kanal-MOS-Transistor (5) zwischen dem Kollektor und der Basis eines zweiten Bipolar-Transistors (9) angeordnet sind und mit Widerständen, JFET's und MOS- und Bipolar-Transistoren, die zur Basis-Emitter-Strecke des ersten und zweiten Bipolar-Transistors (7,9) parallelgeschaltet sind, wobei das Gate des MOS-Transistors mit dem Ausgang (8) verbunden sein kann, dadurch gekennzeichnet, daß von der Basis eines ersten Bipolar-Transistors (7) nach Masse (6) die Source-Drain-Strecke eines ersten p-JFET (2) angeordnet ist, daß das Gate des ersten p-JFET (2) mit dem Kollektor des ersten Bipolar-Transistors (7), dem Drain des n-MOS-Transistors (3) auf der Eingangsseite und mit dem Ausgang (8) verbunden ist, daß die Source-Drain-Strecke eines zweiten p-JFET (4) zwischen der Basis und dem Emitter eines zweiten Bipolar-Transistors (9) angeordnet ist, daß das Gate des zweiten p-JFET (4) mit dem Kollektor des zweiten Bipolar-Transistors (9), dem Source des p-MOS-Transistors (5) auf der Eingangsseite und der Betriebsspannung (10) verbunden ist und daß der Emitter des Bipolar-Transistors (9) gleichfalls mit dem Ausgang (8) verbunden ist (Fig. 2).

2. Integrierte BICMOS-Schaltungsanordnung nach Anspruch 1, dadurch gekennzeichnet, daß die Drain-Source-Strecke eines zusätzlichen n-MOS-Transistor (12) zwischen der Basis und dem Emitter des zweiten Bipolar-Transistors (9) angeordnet ist, daß sein Gate mit der Betriebsspannung (10) verbunden ist, daß die Drain-Source-Strecke eines weiteren n-MOS-Transistors (11) zwischen der Basis und dem Emitter des ersten Bipolar-Transistors (7) angeordnet ist und daß sein Gate mit der Basis des zweiten Bipolar-Transistors (9) verbunden ist (Fig. 3).

3. Integrierte BICMOS-Schaltungsanordnung nach den Ansprüchen 1 und 2, dadurch gekennzeichnet, daß der n-MOS-Transistor (3) auf der Eingangsseite als Doppeltransistor (3, 3.1) mit gemeinsamen Source- und Gateanschlüssen und zwei Drainanschlüssen ausgebildet ist, daß der zweite Drainanschluß des n-MOS-Doppeltransistors (3.1) mit der Basis des zweiten Bipolar-Transistors (9) verbunden ist, daß die Drain-Source-Strecke eines weiteren n-MOS-Transistors (11) zwischen Basis und Emitter des ersten Bipolar-Transistors (7) angeordnet ist und daß sein Gate mit der Basis des zweiten Bipolar-Transistors (9) verbunden ist (Fig. 4).
